# EUROPEAN PATENT SPECIFICATION

(11) **EP 0 453 237 B1**
(45) Date of publication and mention of the grant of the patent: **09.12.1998**
(21) Application number: 91303379.1
(22) Date of filing: 16.04.1991
(51) Int. Cl.: G03F 7/037

(54) **Photosensitive, heat-resistant resin composition and pattern formation process**
Photoempfindliche hitzebeständige Harzzusammensetzung und Verfahren zur Herstellung von Mustern
Composition résineuse photosensible résistante à la chaleur et méthode de fabrication de motifs

(30) Priority: 16.04.1990 JP 99788/90; 19.10.1990 JP 279088/90
(43) Date of publication of application: 23.10.1991
(73) Proprietor: FUJITSU LIMITED, Kawasaki-shi, Kanagawa 211 (JP)
(72) Inventor: Tani, Motoaki, Atsugi-shi, Kanagawa 243 (JP); Horikoshi, Eiji, Isehara-shi, Kanagawa 259-11 (JP); Watanabe, Isao, Sagamihara-shi, Kanagawa 228 (JP)
(74) Representative: Silverman, Warren

(56) References cited:
- DE-A- 2 914 619
- PATENT ABSTRACTS OF JAPAN vol. 12, no. 453 (P-792)(3300) 29 November 1988 & JP-A-63 175 854 ( HITACHI CHEM. CO. ) 20 July 1988
- WORLD PATENTS INDEX Week 8006, Derwent Publications Ltd., London, GB; AN 80-10213C & JP-A-54 162 798 (DENKI KAGAKU) 24 December 1979

## Description

The present invention relates to a film forming, photosensitive, heat-resistant resin composition and a process for the formation of a heat-resistant insulating resin pattern. A film formed from the photosensitive, heat-resistant resin composition of the invention (in the present specification, the term "film" is used in a broad sense to indicate various coatings, films, thin films, etc.) has an excellent adhesion to the base material and good heat resistance, moisture resistance, insulating properties, toughness, abrasion resistance, and weather resistance, and further, can be formed at a low cost. The process for formation of a pattern according to the present invention is advantageous in that a photoresist for masking is not necessary. A pattern of a heat-resistant insulating resin film formed by this process is useful as one component of a circuit board or a semiconductor device, and can be utilized, for example, as a protective film or an insulating film (layer insulating film) in printed circuits, printed boards, wiring boards, and electronic components for high-density mounting. The term "base material" or "base material to be treated" used in the present specification refers to; general-use substrates including semiconductor substrates, ceramic substrates, metallic substrates, and various layered films and wiring.

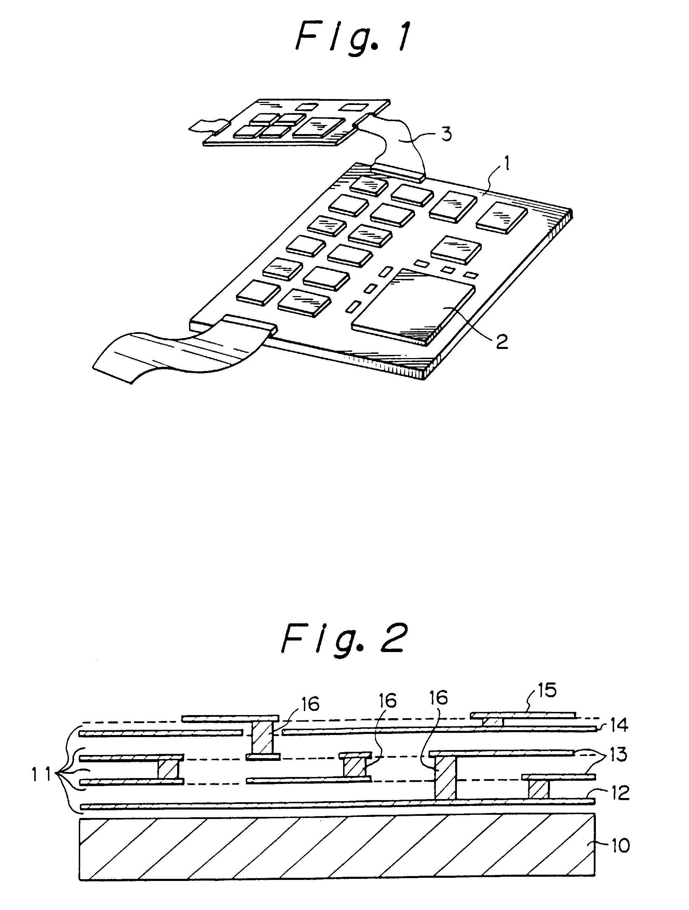

Solder jointing is used for mounting IC chips in printed circuits, printed boards, wiring boards and electronic components including multi-chip modules or the like (as exemplified in Figs. 1 and 2 of the accompanying drawings) for high-density mounting. Accordingly, the insulating films used for the above-described circuit substrates should be able to withstand the heat applied during soldering. Further, since a large amount or inrormation must be rapidly processed, reductions in the size and increases in the volume of information processors are required. Semiconductor devices constituting a major part of such information processors have been integrated through a reduction in the size of unit elements, thus enabling LSIs and VLSIs to be put to practical use. The quantity of heat (heat value) emitted from the semiconductor device increases with an increase in the integration of unit elements: in an LSI, the heat value amounts to about 10 W.

Integration is achieved by a multi-layerization of the circuit. When forming a semiconductor integrated circuit element, an insulator is needed for insulating layers and for protecting the surfaces. Inorganic insulators, such as phosphosilicate glass ("PSG"), silicon dioxide (SiO₂) and silicon nitride (Si₃N₄), are used for this purpose.

Although the above-described inorganic insulators have excellent properties, such as a dielectric strength and heat resistance, it is difficult to form an insulating film having a large thickness because the insulating film is formed by a chemical vapour deposition process ("CVD").

The surface of a semiconductor substrate to be coated with an insulating film has a significant number of fine uneven portions having a large aspect ratio. Because the above inorganic insulating films are prepared in a film form similar to the form of the surface of the substrate, it may be impossible to smooth the substrate surface and provide sufficient coverage.

Accordingly, investigations have been made into the use of polyimide (which can be coated by spin coating and has an excellent heat resistance) not only as a surface protective film of a semiconductor integrated circuit element but also as a layer insulating film. The polyimide film can be formed by dissolving a polyimide precursor, such as bismaleimide, polyamide acid or diamine, in a solvent, such as N-methyl-2-pyrrolidone ("NMP"), coating the resulting solution on a semiconductor substrate by for example spin coating, and heating the coating to a temperature of 150 to 400°C to cause a cyclodehydration reaction, and thus cause the coating to be cured. The cyclodehydration reaction is also referred to as a polyimidization reaction. Since the thus-formed polyimide has no photosensitivity in itself, a fine pattern of the polyimide must be formed by coating a photoresist on a film of polyimide precursor, forming a resist pattern by photolithography, transferring the resist pattern to the polyimide precursor layer by wet etching or plasma etching to form a pattern comprising a polyimide precursor, and heat-treating the pattern to cause a cyclodehydration reaction, to thereby form a polyimide pattern.

A polyimide having photosensitivity in itself, which enables a polyimide to be patterned to any form, has been developed and is commercially available from various manufacturers. With this photosensitive polyimide, a photosensitive functional group is introduced into the molecule of a polyimide precursor. A photoreaction can be conducted only in an exposed portion thereby to polymerise the exposed precursor. Because the unexposed portion and the exposed portion have different solubilities, development can then be conducted by using a solvent to dissolve and remove the unexposed portion while leaving only the exposed portion.

In a subsequent heat treatment, the photosensitive group, which has a poor heat resistance, is thermally decomposed and removed with the advance of cyclodehydration, so that only a polyimide portion having good heat resistance remains. The photosensitive group can be introduced into the polyimide precursor through a covalent bond, an ionic bond or the like.

However, the use of the above-described photosensitive polyimide has the problems that the photosensitive polyimide is expensive and that there is a large reduction of the film thickness due to the decomposition of the photosensitive group.

Furthermore, both the non-photosensitive polyimide and photosensitive polyimide have a poor moisture resistance.

For reference, the following patents describe a process for the formation of a pattern.

Japanese Unexamined Patent Publication (Kokai) No. 56-22428 discloses a process for the formation of a polyimide pattern, comprising the steps of (1) forming a film of a photosensitive polyimide precursor on a substrate; (2) irradiating the film with light in a pattern form and conducting development; (3) heating the developed polyimide precursor pattern to convert the pattern to a polyimide pattern; and (4) treating the resultant polyimide pattern with an etchant for polyimide. A polyimide precursor bonded to a photosensitive group through a chemical bond or mixed with a photosensitive compound (such as bichromate) is used as the photosensitive polyimide precursor. In this process, the development residue of the unexposed portion can be easily removed, so that a through-hole free from defects can be obtained.

Japanese Unexamined Patent Publication (Kokai) No. 59-107346 discloses a heat-resistant photosensitive material comprising a photosensitive polyimide precursor including structural units represented by the following formula: 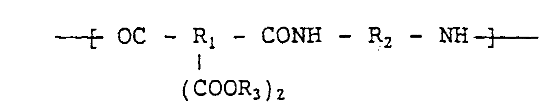 wherein R₁ and R₂ are each an aromatic ring group, R₃ is a thietane ring, and COOR₃ is bonded to the amide group at its ortho-position. An insulating, heat-resistant polyimide pattern having good adhesion to the semiconductor substrate can be prepared by patterning the photosensitive material on the substrate.

In addition to these documents, although it is not considered to be relevant to the present invention, Japanese Unexamined Patent Publication (Kokai) No. 54-109828 discloses a heat-resistant photoresist composition which comprises 100 parts by weight of at least one polymer selected from a variety of organic polar solvent-soluble, heat-resistant polymers including polyimide, and 0.1 to 100 parts by weight, preferably 1 to 50 parts by weight of a monomeric compound containing at least two ethylenically unsaturated double bonds in a molecule thereof. The amount of the monomeric compound incorporated into the heat-resistant polymer should not exceed 100 parts by weight, because such amount causes a reduction of the heat resistance of the resulting photoresist. This is because the selected monomeric compounds do not exhibit an excellent heat resistance after curing of the resist.

It is desirable to use a photosensitive polyimide as a layer-insulating film in the production of an integrated circuit which generates a considerable amount of heat during use. However, as described above, this photosensitive polyimide has the problem that the patterning precision is lowered due to the reduction in the film thickness by the decomposition of a photosensitive group when the photosensitive polyimide precursor is heat treated to convert it into a polyimide. Furthermore, the material has a high cost.

Accordingly, an object of the present invention is to provide a film-forming, photosensitive, heat-resistant resin composition which is useful in the production of circuit substrates and semiconductor devices for high-density mounting including multi-chip modules or the like, such as printed circuits, printed boards, wiring boards and electronic components, which causes no reduction in the film thickness during the formation of a film, and which is low in cost.

Another object of the present invention is to provide an improved patterning process for the formation of a heat-resistant insulating resin pattern through the use of a photosensitive, heat-resistant resin composition without the aid of a photoresist.

Still another object of the present invention is to provide a circuit board produced by using the above pattern formation process.

To attain these objects, the present inventors made intensive and extensive studies and, as a result, found that the use of a polyimide precursor having no photosensitivity in itself in combination with a particular polymerizable monomer or oligomer can eliminate the problems of the conventional photosensitive polyimide and enables a polyimide film for use as a surface protective film or a layer-insulating film to be formed at a much lower cost than that of the conventional process.

According to one aspect of the present invention, there is provided a film forming, photosensitive, heat-resistant composition, which comprises a varnish of polyimide precursor having no photosensitivity and capable of undergoing a cyclodehydration reaction upon heating to form a polyimide, a photopolymerizable component compatible with said polyimide precursor varnish and capable of providing a thermostable polymer upon being photopolymerized, said component being selected from photopolymerizable trifunctional or higher functional acrylic or methacrylic monomers and oligomers and photopolymerizable phosphazenic monomers or oligomers, and a polymerization initiator capable of initiating polymerization of said photopolymerizable component.

According to another aspect of the present invention, there is provided a process for patterning a substrate, which comprises the steps of: coating a substrate with a photosensitive, heat-resistant resin composition according to the first aspect of the invention; selectively exposing the resulting coating of the photosensitive, heat-resistant resin composition in accordance with a predetermined pattern to induce photopolymerization of said photopolymerizable component in a pattern matching the selected pattern; selectively removing a region of said coating other than that where a polymer of said monomer or oligomer has been formed; and heat-treating the residual coating to cause cyclodehydration and curing of said polyimide precursor contained in the coating thereby forming a patterned film of the polyimide and the thermostable polymer.

Such a patterning process may be used in production of a substrate for an electrically conductive circuit for use in high density mounting, in particular in the production of printed circuit, a printed circuit board, a printed wiring, board or an electronic component.

According to another aspect of the present invention, there is provided a circuit board, which comprises a substrate and two or more electrically conductive layers applied over the substrate, the electrically conductive layers being insulated from each other by means of upper and lower layer-insulating films, and being electrically connected with another electrically conductive layer through an interlayer conductor occupying a viahole in the layer-insulating film sandwiched therebetween, and in which the viahole-containing layer-insulating film has been prepared by the steps of providing on an electrically conductive layer as a base material a photosensitive, heat-resistant resin composition according to the first aspect of the invention; selectively exposing the resulting coating of the photosensitive, heat-resistant resin composition in accordance with a predetermined pattern to induce photopolymerization of said, photopolymerizable component in a pattern matching the selected pattern; selectively removing a region of said coating other than that where a polymer of said monomer or oligomer has been formed; and heat-treating the residual coating to cause cyclodehydration and curing of said polyimide precursor contained in the coating thereby forming a patterned film of the polyimide and the thermostable polymer.

The substrate used herein in the production of a circuit board is preferably a member selected from the group consisting of a semiconductor substrate, a ceramic substrate, a metallic substrate, an inorganic substrate and an organic substrate.

For a better understanding of the invention and to show how the same may be carried into effect, reference will now be made by way of example only to the accompanying drawings in which:
Fig. 1 is a perspective view showing one embodiment of a prior art multi-chip module to which the present invention is applicable;
Fig. 2 is a cross-sectional view of the multi-chip module of Fig. 1;
Figs. 3A to 3D are cross-sectional views showing, in sequence, one embodiment of the pattern formation process of the present invention; and
Figs. 4A to 4C are schematic views showing, in sequence, the conversion of a polyimide precursor to polyimide.

In the present invention, a film forming, photosensitive, heat-resistant resin composition is prepared by combining a polyimide precursor having no photosensitivity in itself used in the form of a lacquer with a photopolymerizable component as aforesaid.

As described above, the present inventors have sought to eliminate the problems of the use of a photosensitive polyimide and, furthermore, have sought to form a polyimide film for a layer-insulating layer at a much lower cost than that of the conventional process. As a result they have found that, when a base material to be treated is coated with a mixture of the photopolymerizable component capable of forming a polymer having excellent heat resistance with a varnish of a polyimide precursor, subjected to selective exposure through the use of amask or the like and developed, the polyimide precursor varnish may be dissolved out and removed together with untreated photopolymerizable component while the varnish of the polyimide precursor remains in an exposed portion together with a polymer derived from the photopolymerizable component.

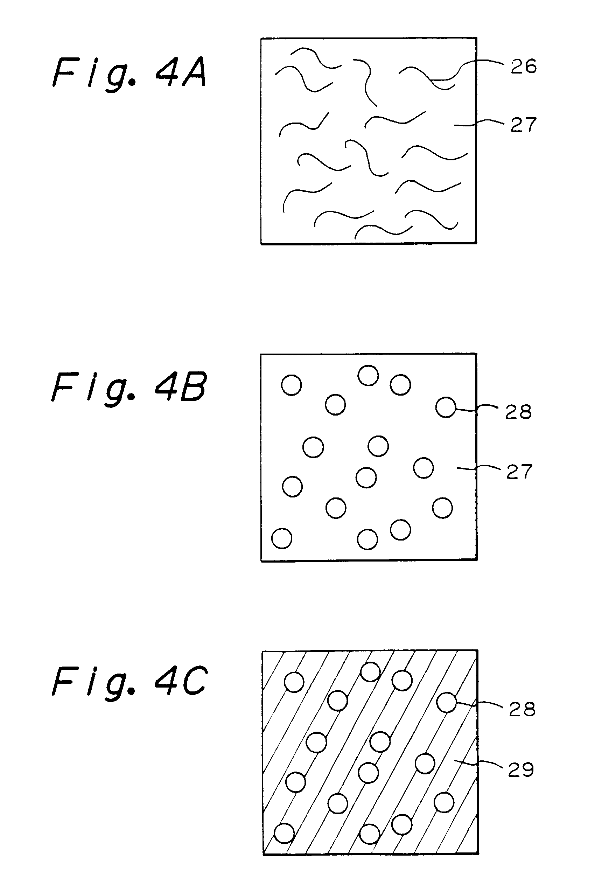

When the residual varnish of the polyimide precursor together with the polymer derived from the photopolymerizable component in the exposed portion is then heat-treated, a cyclodehydration reaction of the polyimide precursor proceeds, thus causing the polyimide precursor to be converted into a polyimide. Nevertheless, since the polyimide resin pattern thus formed is a mixture of a polyimide with the polymer of the photopolymerizable component, the heat resistance is inferior to that of a pattern consisting of a polyimide only. The nature of the product of exposing the patterned and photoreacted material to elevated temperature is uncertain, but it would seem to contain a copolymer of a polyimide with the polymer and it will be described as such hereinafter with reference to Figs. 4A to 4C. The use of a photopolymerizable monomer having excellent heat resistance as the photopolymerizable component enables the electrical properties required in electronic components, such as heat resistance and insulating properties, to be sufficiently maintained.

Specifically, in JIS (Japanese Industrial Standard) standards, heat resistance during soldering at 270°C is specified as being needed by electronic components, and the photosensitive, heat-resistant resin product derived from the photosensitive, heat-resistant resin composition can sufficiently meet the heat resistance standard specified in the JIS standards.

As a result of experiments, the present inventors have found that the properties of the photosensitive, heat-resistant resin depend upon the properties of the photopolymerizable component and photopolymerization initiator, rather than the varnish of a polyimide precursor.

In the practice of the present invention, any precursors of various polyimides (including modified products) can be used. According to the findings of the present inventors, the polyimide precursor may be prepared according to need or a commercially available polyimide precursor may be used without any significant difference being observed in the effect of these polyimides. Suitable polyimide precursors for use in the practice of this invention are precursors of polyimides as such, precursors of modified polyimides, precursors of polybismaleimide and precursors of modified polybismaleimides. Similarly, polyimide engineering plastics also may be used. The above-described precursors may be used alone or in the form of mixtures thereof.

The photopolymerizable component compatible with the varnish and capable of providing a thermostable polymer upon being polymerized preferably is an acrylic or methacrylic monomer or oligomer, having an isocyanurate structure. Otherwise, the monomer or oligomer may have an acryloyl or methacryloyl group in a terminal and/or a side chain in its molecule, or be an oligoester acrylate. Alternatively, the photopolymerizable monomer may be a phosphazenic monomer or oligomer. The above-described photopolymerizable monomers or oligomers can be usually polymerized through the action of light or heat and hence are preferred for use as the photopolymerizable component.

The present inventors have studied photopolymerizable monomers or oligomers having a good compatibility with the polyimide precursor and capable of providing a polymer having good heat resistance, and, as a result, have found that acrylic or methacrylic monomers or oligomers which are commonly used as an ultraviolet curable adhesive are suitable.

The tri- or higher functional acrylic or methacrylic monomer or oligomer may be a polyester acrylate, epoxy acrylate, urethane acrylate or silicone acrylate monomer or oligomer. Tri- or higher functional acrylate monomers or oligomers having an isocyanurate structure, for example, tris(acryloyloxyethyl) isocyanurate, isocyanuric acid EO (n = 3)·ε-caprolactone modified triacrylate, and branched polyfunctional acrylate monomers or oligomers, for example, trimethylolpropane triacrylate, EO-modified trimethylolpropane triacrylate, pentaerythritol triacrylate, pentaerythritol tetraacrylate, and pentaerythritol hexaacrylate are particularly useful. Corresponding methacrylate monomers or oligomers may also be used but there is then a slight lowering in photosensitivity. It has been found that, when a lowering of the dielectric constant of the insulating film is required, a blend of tri- or higher functional acrylic or methacrylic fluoromonomer or fluorooligomer provides good results.

Further, the present inventors have found that inorganic polymer precursors used in the ultraviolet curable coating materials, specifically phosphazenic monomers or oligomers are also suitable as the photopolymerizable component.

The phosphazene compounds are known to be coating materials having good heat resistance (see Japanese Unexamined Patent Publication (Kokai) No. 63-241075). In the invention described in this publication, the phosphazene compounds are intended for use as a coating material for protecting the surface of decorative sheets, woods, plastics, paper, and clothes. For this reason, even if the phosphazene compound is used in a filler, the filler is limited to inorganic fillers and inorganic materials such as silica. The disclosure in this publication is not directed towards any teaching of the use of the phosphazene compound in combination with an organic material. In particular, unlike the present invention, the above-described publication does not disclose applications wherein the phosphazene compound is combined with a polyimide precursor for use as a photosensitive insulating film which is selectively patterned in the same manner as that used in the photosensitive polyimide.

The phosphazenic monomer is preferably the following compound wherein the chloro portion of the hexachlorocyclo-triphosphazene [3PNC] is substituted with, for example, an acrylate group, a methacrylate group, a vinyl group, or an allyl group.

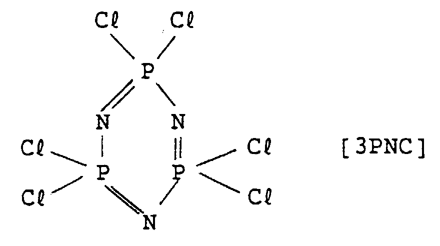

Specific examples of such substituting groups include a residue formed by removing a hydrogen atom from a hydroxyl group in methacrylates such as 2-hydroxyethyl methacrylate, 2-hydroxypropyl methacrylate and 2-hydroxymethyl methacrylate (a hydroxyalkyl methacrylate residue), and a residue formed by removing a hydrogen atom from a hydroxyl group in acrylates such as 2-hydroxyethyl acrylate and 2-hydroxybutyl acrylate and 3-hydroxy-2-tert-butylpropyl acrylate (a hydroxyalkyl acrylate residue).

A residue formed by removing a hydrogen atom from a hydroxyl group in 2-hydroxyethyl methacrylate and a residue formed by removing a hydrogen atom from a hydroxyl group in 2-hydroxyethyl acrylate are particularly preferred. When the merits of the above-described various hydroxyalkyl methacrylate residues are compared with those of the hydroxyalkyl acrylate residues, the hydroxyalkyl acrylate residues are considered better because the crosslinking rate is higher. Further, the use of the phosphazenic monomer or oligomer in the form of a mixture with a tri- or higher functional acrylate or methacrylate monomer not containing any inorganic material is also possible.

Reverting to the acrylic or methacrylic monomers or oligomers which may be used, the present inventors have found that the following acrylic oligomers, which have been used as an ultraviolet curable adhesive, are also suitable as the polymerizable oligomer.

It has been found, in particular, that oligomers or oligoester acrylates having a methacryloyl group in its terminal or side chain are especially useful as the acrylic oligomer. Except for special cases, an oligomer having an acryloyl group provides a higher reactivity and sensitivity than an oligomer having a methacryloyl group. More specifically, it has been found that trifunctional or higher functional acrylic oligomers having the following structure are particularly useful. 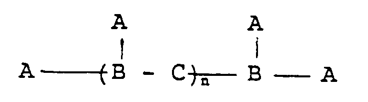 wherein A is an acrylic acid, for example, acrylic acid or methacrylic acid-derived residue;

B is a polyhydric alcohol-derived residue, for example, a 2-ethyl-2-hydroxymethyl-1,3-propanediol or pentaerythritol-derived residue; and

C is a polybasic acid-derived residue, for example, a 3-cyclohexene-1,2-dicarboxylic acid or 4-cyclohexene-1,2-dicarboxylic acid-derived residue.

The polymerization of the photopolymerizable monomers or oligomers listed above is induced and proceeds in the presence of a polymerization initiator through the action of light. A radical is generated from the polymerization initiator and this radical induces the polymerization of the photopolymerizable monomer or oligomer. The present inventors have made studies with a view to finding a polymerization initiator useful for the practice of the present invention, and as a result, have found that compounds well known to be capable of generating a radical through the action of light, for example, benzoin ether compounds, ketalin ether compounds, ketal compounds, acetophenone compounds, benzophenone compounds, thioxanthone compounds, organic peroxides, N-phenylglycine, triazine compounds and allene-iron complexes, are suitable. Typical examples of the polymerization initiator are as follows, but it should be understood that the polymerization initiator is not limited to these only.
Benzoin ether compounds:
   isopropyl benzoin ether, isobutyl benzoin ether, etc.
Ketal compounds:
   1-hydroxycyclohexyl phenyl ketone, benzyl dimethyl ketal, etc.
Acetophenone compounds:
   acetophenone, 2-hydroxy-2-methylpropiophenone,
   4-isopropyl-2-hydroxy-2-methylpropiophenone, etc. Benzophenone compounds:
   benzophenone, methyl o-benzoylbenzoate, etc.
Thioxanthone compounds:
   2-methylthioxanthone, 2-chlorothioxanthone, etc.
Organic peroxides:
   ketone peroxide, peroxy ketal, hydroperoxide, dialkyl peroxide, diacyl peroxide, peroxy ester, peroxy dicarbonate, etc.
Triazine compounds:
   Compounds having a 1,3,5-triazine structure and at least one trichloromethyl group in their molecule, such as 2,4,6-tris(trichloromethyl)-1,3,5-triazine and 2,4-bis (trichloromethyl)-6-phenyl-1,3,5-triazine.
Allene-iron complexes:
   (η⁶-benzene) (η⁵-cyclopentadienyl) iron (II) hexafluorophosphate, (η⁶-pyrene) (η⁵-cyclopentadienyl) iron (II) hexafluoroantimonate, (η⁶-naphthalene) (η⁵-cyclopentadienyl) iron (II) hexafluorophosphate, etc.

The above-described polymerization initiators may be used alone or in the form of a mixture thereof. Further, it is possible to enhance the sensitivity through exposure at an optimal wavelength.

Further, the use of the above-described polymerization initiator in combination with a sensitizer is recommended from the viewpoint of the effect achievable. Examples of suitable sensitizers include di-n-butylamine, n-butylamine, triethylamine and triethylenetetramine, as well as ketocoumarin dyes, coumarin dyes, thioxanthene dyes, xanthene dyes and thiopyrylium salt dyes.

The proportions of the polyimide precursor, photopolymerizable component and polymerization initiator in the heat-resistant resin composition according to the present invention may be widely varied depending upon factors such as desired results. The present inventors have found it useful to employ the above-described acrylic monomer or oligomers in an amount of 10 to 500% by weight based on the polyimide precursor (weight of the polyimide precursor contained in the varnish) and the polymerization initiator in an amount of 0.1 to 50% by weight based on the monomer or oligomer. Since the photopolymerizable component is less expensive than the polyimide precursor, the cost of the resultant photosensitive, heat-resistant resin film or a pattern per se formed therefrom drops as the amount of photopolymerizable monomer or oligomer increases. Further, the photosensitivity is increased with increase in the amount of photopolymerizable component and photopolymerization initiator.

The formation of the heat-resistant, insulating resin pattern according to the present invention starts with the coating of the photosensitive, heat-resistant resin composition on the base material to be treated. The coating is conducted by uniformly applying a resin composition in the form of a photosensitive liquid or the like to the surface of a selected base material, for example, a ceramic substrate, such as alumina (Al₂O₃), or a metallic substrate, a semiconductor substrate (for example, a silicon substrate or a sapphire substrate) or the like in the case of use as circuit substrates, printed boards and wiring boards for high-density mounting including multi-chip module by the conventional coating process, such as spin coating, dip coating or doctor blade coating. The coating of the photosensitive, heat-resistant resin composition thus formed is prebaked at an elevated temperature to evaporate to some extent solvent contained therein (the varnish containing the polyimide precursor usually contains 80% by weight or more of N-methyl-2-pyrrolidone as solvent).

After the prebaking, the resultant coating is exposed to conditions capable of inducing photopolymerization of the photopolymerizable component in a predetermined pattern which is the pattern required for the eventual heat-resistant, insulating resin film. Preferably, a pattern of light necessary for generating free radicals from the photopolymerization initiator which is present is applied to the coating. Specifically, selective irradiation with light, such as ultraviolet light, is conducted through a mask. Consequently, only the photopolymerizable monomer or oligomer contained in the exposed portion is selectively polymerized.

Then, the regions in the coating other than where a polymer has been formed from the photopolymerizable monomer or oligomer are selectively removed. Use is made for this purpose of a developing solution comprising a solvent capable of dissolving the polyimide precursor and untreated photopolymerizable monomer or oligomer.

Subsequently, the coating remaining undissolved and unremoved in the developing is heat-treated to polymerize the polyimide precursor in the coating. The heat treatment temperature (heating temperature) in this step is not particularly limited as long as the polyimide precursor is converted into a polyimide without decomposition of the photopolymerized monomer or oligomer taking place. In general, however, the temperature is preferably about 250 to 350°C.

According to the process of the present invention, a heat-resistant, insulating resin pattern having satisfactory properties can be obtained at low cost through the above-described series of steps. Further, it is also possible, when required, to form an unpatterned photosensitive, heat-resistant resin film through the use of this process.

As described above, the present invention can be advantageously used for the production of a multi-chip module. An embodiment of the multi-chip module is shown in Fig. 1 (appearance) and Fig. 2 (cross-section). Specifically, the multi-chip module shown in the drawings is provided with an LSI chip 2 mounted on a substrate 1 and a flexible printed board 3. As shown in Fig. 2, this multi-chip module has a layer structure such that a grounding layer 12, a signal layer 13, an electric power supply layer 14 and a surface electrode layer 15 are successively laminated on a substrate 10, such as a silicon wafer or a ceramic substrate, with interposition between each layer of an insulating layer 11 embodying this invention. An interlayer conductor 16 is filled in viaholes to interconnect the upper and lower conductive layers.

Generally speaking, the multi-chip modules to which the present invention can be applied have a minimum size of approximately 5 cm x 5 cm and include, for example, silicon (Si) wafer having a diameter of 7.6 cm (3 in.) or plate such as glass, aluminum, copper or ceramic plate, having a size of approximately 70 mm x 70 mm. A patterning of the electrical conductor body such as aluminum or copper can be achieved at varied layer thicknesses and pattern widths. The conductor pattern can be formed, for example, by vapour depositing a conductor metal followed by selectively wet etching the deposited metal. A photolithographic process is preferably used in this wet etching. The interlayer insulator or layer-insulating film of the present invention, made of the described heat-resistant composition, can be applied at a film thickness of less than 40 µm.

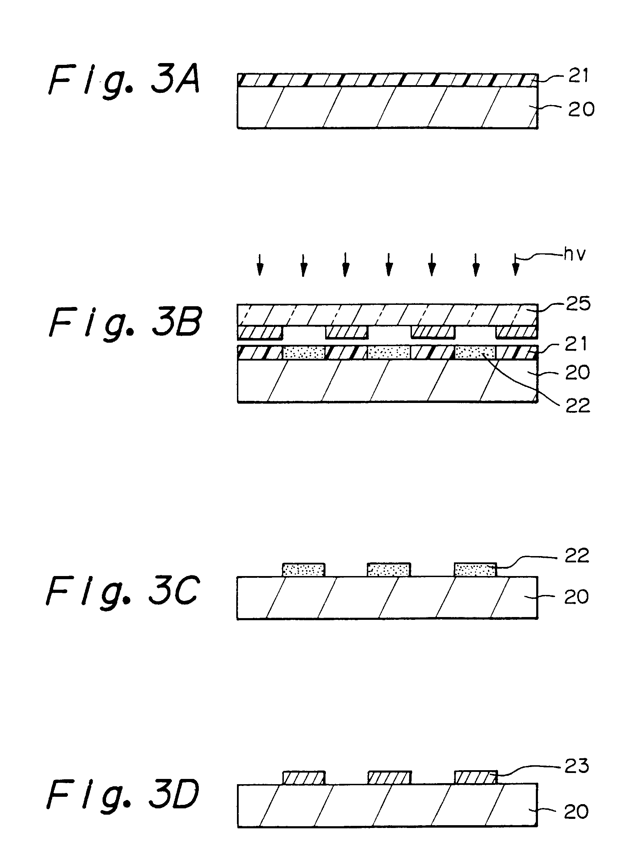

In this connection, the pattern formation process of the present invention will be described with reference to Figs. 3A to 3D and Figs. 4A to 4C.

A photosensitive solution or resin composition of the present invention is spin-coated on a Si wafer having a diameter of 7.6 cm (3 in.), and then prebaked at 90°C for 1 hr. As illustrated in Fig. 3A, a film 21 of the resin composition having a thickness of 5 µm is formed on the Si wafer 20. As shown schematically in Fig. 4A, the film of the resin composition comprises the photopolymerizable monomer (or oligomer) 26 and polyimide precursor 27.

Next, as illustrated in Fig. 3B, a negative type glass mask 25 having a pattern width of 20 µm is disposed over the Si wafer 20. The film 21 of the resin composition is exposed through the glass mask 25 to ultraviolet light having a wavelength of about 250 nm (or radiation having a wavelength of 250 to 400 nm from a Hg lamp) at an exposure level of 480 mJ/cm². As a result of this selective exposure, the unexposed area of the film 21 is not changed, but the exposed area 22 is changed because the photopolymerizable monomer becomes polymerized. As shown in Fig. 4B, the exposed area 22 comprises polyimide precursor 27 and photopolymerization product 28 of the monomer (or oligomer) in addition to the unreacted monomer (or oligomer) (not shown).

After the selective exposure, the film 21 is developed with a solution of N-methyl-2-pyrrolidone in an ultrasonic development procedure. As illustrated in Fig. 3C, the exposed area 22 remains on the wafer 20.

Finally, the wafer 20 is heated at 270°C for 30 min (or at a suitable temperature of 250 to 350°C for a suitable time) to convert the polyimide precursor to polyimide. As illustrated in Fig. 3D, a pattern 23 of the resulting polyimide resin is obtained on the wafer 20. The resulting polyimide resin is shown in Fig. 4C. Namely, the polyimide resin comprises the polymerization product 28 of the monomer (or oligomer) and polyimide 29. Note, Figs. 4A to 4C are schematic views, and therefore the forms and proportions of the components 26, 27, 28 and 29 are illustrated to assist in the understanding of the conversion of polyimide precursor to polyimide resin.

The conversion of polyimide precursor to polyimide resin is represented by the following reaction scheme:

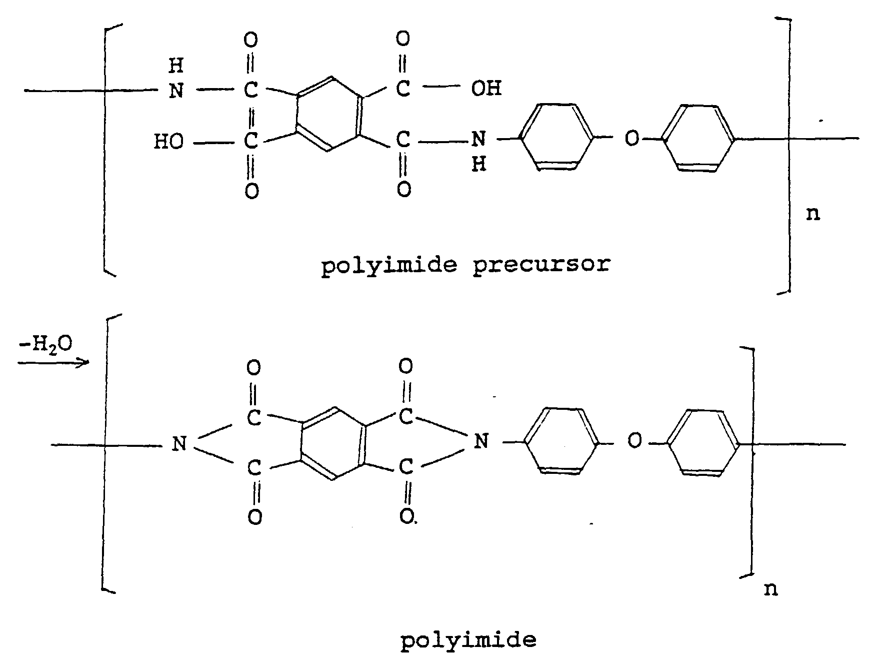

For a further understanding of the present invention, the photosensitive, heat-resistant resin composition according to the present invention and the formation of a pattern using the same will now be described by way of the following Examples.

### Example 1

The use of various polyimide precursors was examined.

Varnishes of a polyimide precursor and of a polybismaleimide precursor, each having a precursor content of 14.5% by weight were prepared, and no significant differences between the performance of the precursors were established when working with the same photopolymerizable monomer and photopolymerization initiator.

| | |
|---|---|
| Varnish of polyimide precursor: (precursor content of varnish: 14.5% by weight) | 50.0 g |
| photopolymerizable monomer: [tris(acryloyloxyethyl) isocyanurate] | 10.0 g |
| photopolymerization initiator: benzophenone | 1.0 g |

A photosensitive solution having the above-described composition was spin-coated on a pretreated Si wafer having a diameter of 7.6 cm (3 in.), and the coated wafer was prebaked at 90°C for 1 hr. to produce a photosensitive plate. The thickness of the film after prebaking was 5 µm.

A negative type glass mask having a minimum pattern width of 30 µm was provided on the photosensitive plate and irradiated with ultraviolet light of a wavelength of 250 nm at an exposure of 480 mJ/cm².

Then, the photosensitive plate was subjected to ultrasonic wave development with N-methyl-2-pyrrolidone and rinsed in ethyl alcohol, thereby developing the plate. The unexposed region was eluted or dissolved while leaving the exposed pattern region only.

The plate was then heated at 270°C for 30 min to convert the residual polyimide precursor into a polyimide resin. As a result, although the depth of yellow colour in the patterned region slightly increased, no other change was observed.

The resulting pattern was observed under a microscope, and no breaks were found in any sample. The thermal decomposition temperature of the resin in the pattern region was measured, and it was found that the resins were stable up to about 350°C, regardless of the types of varnish used as the precursor.

### Example 2

The use of various photopolymerizable monomers was examined.

An experiment was conducted in the same manner as in Example 1, except that the same kind of polyimide precursor varnish was used in-each case and same photopolymerization initiator as in Example 1 was used. Four different photopolymerizable monomers were investigated. Exposure was achieved by irradiating the photosensitive plates with ultraviolet light having a wavelength of 250 nm.

The identity of the photopolymerizable monomer, exposure and thermal decomposition temperature are given in Table 1, in which the identity and amount of the photopolymerizable monomer indicated by Nos. 1 to 5 are as follows:
- No. 1:: tris(acryloyloxyethyl) isocyanurate (10 g) (the same material as that used in Example 1)
- No. 3:: pentaerythritol triacrylate (20 g)
- No. 4:: dipentaerythritol hexaacrylate (15 g)
- No. 5:: mixture of tris(acryloyloxyethyl) isocyanurate (6 g) with trimethylolpropane triacrylate (4 g)

The patterns were observed under a microscope, and no breaks were found in any sample. The thermal decomposition temperature of the resin in the patterned region was measured, and as a result, was found to be 280 to 400°C.

**Table 1**

| Photopolymerizable monomer | Exposure (mJ/cm²) | Decomposition temp. (°C) |
|---|---|---|
| No. 1 | 480 | 350 |
| No. 3 | 400 | 280 |
| No. 4 | 640 | 300 |
| No. 5 | 560 | 320 |

### Example 3

The use of various photopolymerization initiators was examined.

An experiment was conducted in the same manner as that of Example 1, except that the same polyimide precursor varnish and the same photopolymerizable initiator as in Example 1 were used with six different photopolymerization initiators given below. The photosensitive plates were irradiated with ultraviolet having a wavelength of 250 nm with suitable exposures.

The identity and amount of photopolymerization initiator and the exposure necessary for the formation of a pattern are given in Table 2, in which the identity and amount of the photopolymerization initiator indicated by Nos. 1 to 6 are as follows:
- No. 1:: benzophenone (1.0 g) (the same material as that used in Example 1).
- No. 2:: 3,3'-4,4'-tetra-(tert-butylperoxycarbonyl) benzophenone (0.80 g)
- No. 3:: isopropyl benzoin ether (2.0 g)
- No. 4:: 2-hydroxy-methyl-propiophenone (0.50 g)
- No. 5:: 2-methylthioxanthone (0.20 g)
- No. 6:: 2,4-bis(trichloromethyl)-6-phenyl-1,3,5-triazine (1.50 g)

The patterns were observed under a microscope, and no breaks were found in any sample.

These results were obtained when development was conducted in the same manner as that described in Example 1, and do not reflect the different sensitivities of the photopolymerization initiators. Therefore, it has been found that the sensitivity varies with the amount of photopolymerization initiator added and the development conditions.

**Table 2**

| Photopolymerization initiator | Exposure (mJ/cm²) |
|---|---|
| No. 1 | 480 |
| No. 2 | 400 |
| No. 3 | 400 |
| No. 4 | 800 |
| No. 5 | 1,280 |
| No. 6 | 560 |

### Example 4

The use of a modified polyimide precursor was examined, with a composition comprising the following being utilised:

| | |
|---|---|
| varnish of polyimide precursor: silicone-modified polyimide (precursor content of varnish: 13.5% by weight) | 50.0 g |
| photopolymerizable monomer: pentaerythritol tetraacrylate | 12.0 g |
| photopolymerization initiator: benzoyl peroxide | 2.0 g |

A photosensitive solution having the above-described composition was spin-coated onto a pretreated Si wafer having a diameter of 7.6 cm (3 in.), and the coated wafer was prebaked at 120°C for 1 hr. to produce a photosensitive plate. The thickness of the film after the prebaking was 6 µm.

A negative type glass mask having a minimum pattern width of 30 µm was provided on the photosensitive plate and irradiated with a high-pressure mercury lamp for 20 sec.

Then, the photosensitive plate was subjected to ultrasonic wave development with a mixed solution comprising N-methyl-2-pyrrolidone and methyl cellosolve and rinsed in isopropyl alcohol, thereby developing the plate. The unexposed region was eluted while leaving the exposed pattern region only.

The plate was then heated at 300°C for 30 min to convert the residual polyimide precursor into a polyimide resin. Although the depth of yellow colour of the pattern region was slightly increased, no other change was observed.

The pattern was observed under a microscope, and no breaks were found in any sample. The thermal decomposition temperature of the resin in the pattern region was measured, and it was found that the resin was stable up to about 300°C.

### Example 5

The photopolymerizable monomer used in this Example was a phosphazene-derived monomer. The working composition was as follows:

| | |
|---|---|
| varnish of polyimide precursor: polyimide precursor (14.5% by weight) | 50.0 g |
| | |
| phosphazene monomer: HEMA6-substituted 3PNC (3PNC in which each of six (6) chlorine substituents is substituted with 2-hydroxyethyl methacrylate) | 10.0 g |
| | |
| photopolymerization initiator: 2,2-dimethoxy-2 phenylacetophenone | 1.00 g |
| | |
| solvent: methyl ethyl ketone | 10.0 g |

A photosensitive solution having the above-described composition was spin-coated on a pretreated Si wafer having a diameter of 7.6 cm (3 in.), and the coated wafer was prebaked at 90°C for 1 hr. to produce a photosensitive plate. The thickness of the film after the prebaking was 3 µm.

A negative type glass mask having a minimum pattern width of 30 µm was provided on the photosensitive plate and irradiated with ultraviolet light from a high-pressure mercury lamp (wavelength: 250 - 400 nm) at an exposure of 500 mJ/cm² (in terms of a wavelength of 365 nm).

Then, the photosensitive plate was subjected to ultrasonic wave development with N-methyl-2-pyrrolidone and rinsed in ethyl alcohol, thereby developing the plate. The unexposed region was eluted while leaving the exposed pattern region only.

The pattern region was then heated at 260°C for 30 min to convert the residual polyimide precursor into a polyimide resin. Although the depth of yellow colour of the pattern region was slightly increased, no other change was observed.

The pattern was observed under a microscope, and no breaks were found. The thermal decomposition temperature of the resin in the pattern region was measured, and the resin was found to be stable up to about 350°C.

### Examples 6 to 8

Patterns were formed in the same manner as that of Example 5, except that there were used in the respective examples HEA6-substituted 3PNC (3PNC in which each of six Cl substituents is substituted with 2-hydroxyethyl acrylate) as in Example 5, but in smaller amounts, a mixture of HEMA6-substituted 3PNC with trimethylolpropane triacrylate or a mixture of HEMA6-substituted 3PNC with pentaerythritol triacrylate and isocyanuric acid EO-modified (n = 3) triacrylate was used instead of HEMA6-substituted 3PNC. When the products obtained were observed under a microscope, no abnormal portions were found. The thermal decomposition temperature of the resin in the pattern region was measured in each case. The results for Examples 5 to 8 are given in the following Table 3.

**Table 3**

| Ex.No. | Monomer | Exposure (mJ/cm²) | Thermal decomposition temp.(°C) |
|---|---|---|---|
| 5 | HEMA6-substituted 3PNC (10.0 g) | 500 | 350 |
| | | | |
| 6 | HEA6-substituted 3PNC (6.0 g) | 750 | 400 |
| | | | |
| 7 | HEMA6-substituted 3PNC (8.0 g) + trimethylolpropane triacrylate (4.0 g) | 350 | 330 |
| | | | |
| 8 | HEMA6-substitued 3PNC (5.0 g) + pentaerythritol triacrylate (5.0 g) + isocyanuric acid EO-modified (n = 3) triacrylate (5.0 g) | 400 | 360 |

### Examples 9 to 13

Different exposures suitable for the formation of a pattern were examined in the same manner as that of Example 5, except that 3,3'-4,4'-tetra-(tert-butylperoxycarbonyl) benzophenone, isopropyl benzoin ether, 2-hydroxy-2-methyl-propiophenone, 2-methylthioxanthone and 2,4-bis (trichloromethyl)-6-phenyl-1,3,5-triazine were used instead of 2,2-dimethoxy-2-phenylacetophenone. The results are given in Table 4. These results were obtained with development being conducted under the same developing conditions as those of Example 5. The sensitivity of the compositions tested did not completely equal the sensitivity of the composition of Example 5. It also has been found that the sensitivity varies with the amount of photopolymerization initiator added and the developing conditions.

**Table 4**

| Ex.No. | Photopolymerization initiator | Exposure (mJ/cm²) |
|---|---|---|
| 5 | 2,2-dimethoxy-2-phenylacetophenone (1.00 g) | 500 |
| | | |
| 9 | 3,3'-4,4'-tetra-(tert-butylperoxycarbonyl) benzophenone (0.80 g) | 250 |
| | | |
| 10 | isopropyl benzoin ether (2.00 g) | 400 |
| | | |
| 11 | 2-hydroxy-2-methyl-propiophenone (0.50 g) | 800 |
| | | |
| 12 | 2-methylthioxanthone (0.20 g) | 1,000 |
| | | |
| 13 | 2,4-bis(trichloromethyl)-6-phenyl-1,3,5-trizaine (1.50 g) | 350 |

### Example 14

A photosensitive solution was made up from the following components:

| | |
|---|---|
| varnish of silicone-modified polyimide precursor: silicone-modified polyimide precursor (13.5% by weight) | 50.0 g |
| | |
| phosphazene monomer: HEA6-substituted 3PNC (3PNC in which each of six Cl substituents is substituted with 2-hydroxyethyl acrylate) | 12.0 g |
| photopolymerization initiator: benzoyl peroxide | 2.00 g |

The photosensitive solution produced having the above-described composition was spin-coated onto a glass substrate having a size of 70 x 70 x 1 mm, and the coated substrate was prebaked at 120°C for 1 hr. The thickness of the film after the prebaking was 5 µm.

A negative type glass mask having a minimum pattern width of 30 µm was provided on the photosensitive plate and irradiated with a high-pressure mercury lamp for 60 sec.

Then, the photosensitive plate was subjected to ultrasonic wave development with a mixed solution comprising N-methyl-2-pyrrolidone and methyl cellosolve and then rinsed in isopropyl alcohol, thereby developing the plate. The unexposed region was eluted, leaving behind the exposed pattern region only.

The pattern region was then heated at 250°C for 50 min to convert the residual polyimide precursor to a polyimide resin. Although the depth of yellow colour of the pattern region was slightly increased, no other change was observed.

The pattern was observed under a microscope, and no breaks were found. The thermal decomposition temperature of the resin in the pattern region was measured, and as a result, the resin was found to be stable up to about 300°C.

### Example 15

A photosensitive solution was made up which comprised the following components:

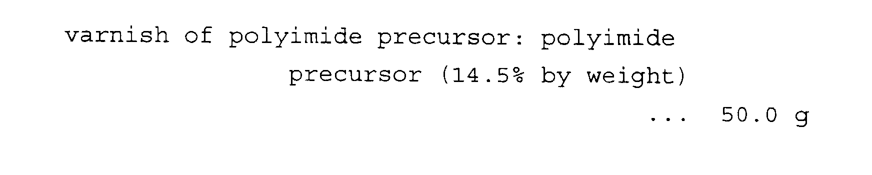

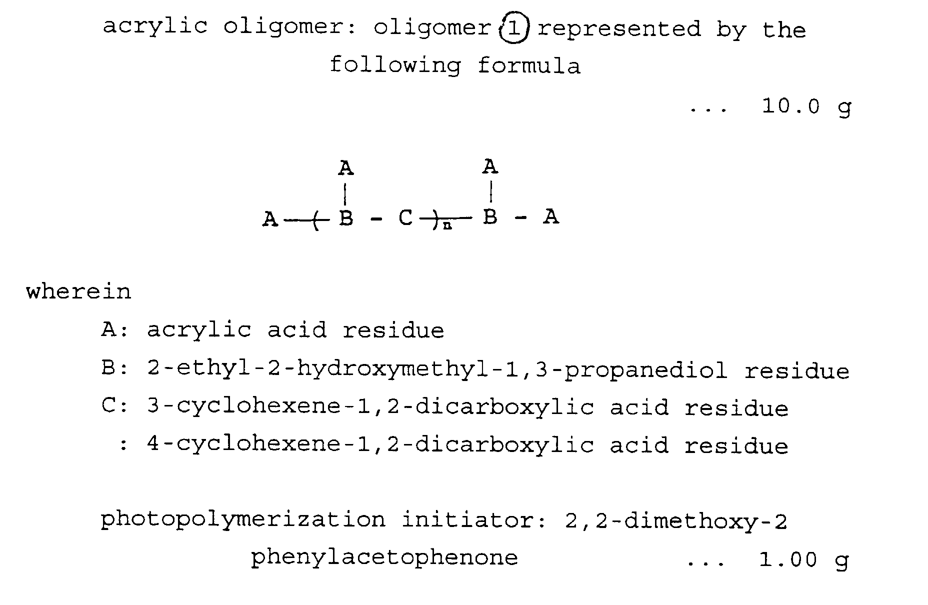

The photosensitive solution having the above-described composition was spin-coated on a silicon wafer having a diameter of 7.6 cm (3 in.), and the coated wafer was prebaked at 120°C for 1 hr. to produce a photosensitive plate. The thickness of the film after the prebaking was 9 µm.

A negative type glass mask having a minimum pattern width of 30 µm was provided on the photosensitive plate and irradiated with ultraviolet by means of an ultraviolet exposing machine at an exposure of 600 mJ/cm² (365 nm).

The photosensitive plate was then subjected to ultrasonic wave development with N-methyl-2-pyrrolidone and was then rinsed in ethyl alcohol, thereby developing the plate. The unexposed region was eluted, leaving behind the exposed pattern region only.

The pattern region was then heated at 300°C for 30 min to convert the residual polyimide precursor to a polyimide resin. Although, the depth of yellow colour of the pattern region was slightly increased, no other change was observed.

The pattern was observed under a microscope, and no breaks were found. The thermal decomposition temperature of the resin in the pattern region was measured, and as a result, the resin was found to be stable up to about 350°C.

### Examples 16 to 20

Patterns were formed in the same manner as that of Example 15, except that there were used as photopolymerizable substance oligomer ②, oligomer ③, a mixture of oligomer ① with pentaerythritol triacrylate, a mixture of oligomer ② with trimethylolpropane triacrylate, and a mixture of oligomer ③ with isocyanuric acid EO-modified (n = 3) triacrylate, instead of acrylic oligomer ① of Example 15. The appearance of the patterns was observed under a microscope, and no breaks were found. The thermal decomposition temperatures of the resins in the pattern region were measured. The results are given in Table 5. 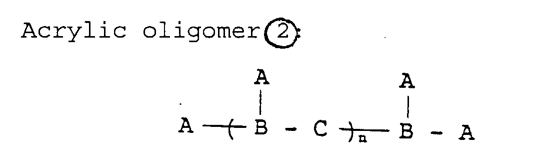 wherein
- A:: methacrylic acid residue
- B:: 2-ethyl-2-hydroxymethyl-1,3-propanediol residue
- C:: 4-cyclohexene-1,2-dicarboxylic acid residue 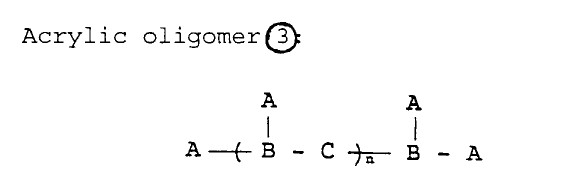
wherein
- A:: acrylic acid residue
- B:: 2-ethyl-2-hydroxymethyl-1,3-propanediol residue
- :: pentaerythritol residue
- C:: 3-cyclohexene-1,2-dicarboxylic acid residue
- :: 4-cyclohexene-1,2-dicarboxylic acid residue

**Table 5**

| Ex.No. | Oligomer | Exposure (mJ/cm²) | Thermal decomposition temp.(°C) |
|---|---|---|---|
| 15 | oligomer ① (10.0 g) | 600 | 350 |
| | | | |
| 16 | oligomer ② ( 5.0 g) | 960 | 400 |
| | | | |
| 17 | oligomer ③ (15.0 g) | 600 | 330 |
| | | | |
| 18 | oligomer ① ( 6.0 g) + pentaerythritol triacrylate ( 6.0 g) | 720 | 300 |
| | | | |
| 19 | oligomer ② ( 6.0 g) + trimethylolpropane triacrylate ( 4.0 g) | 840 | 360 |
| | | | |
| 20 | oligomer ③ ( 5.0 g) + isocyanuric acid EO-modified (n = 3) triacrylate ( 8.0 g) | 800 | 340 |

### Examples 21 to 29

Exposures necessary for the formation of a pattern were determined in the same manner as that of Example 15, except that 3,3'-4,4'-tetra-(tert-butylperoxycarbonyl) benzophenone, isobutyl benzoin ether, benzyl methyl ketal, 2-methylthioxanthone, 2,4,6-tris(trichloromethyl)-1,3,5-triazine, benzoyl peroxide, 2,4-bis(trichloromethyl)-6-phenyl-1,3,5-trizaine, (η⁶-benzene) (η⁵-cyclopentadienyl) (II) hexafluorophosphate and N-phenylglycine were used instead of 2,2-dimethoxy-2-phenylacetophenone as photoinitiators. The results are given in Table 6. These results were obtained when development was conducted under the same developing conditions as those of Example 15 and indicated generally lower sensitivity of photopolymerization initiator used. It was also found that the sensitivity varies with the amount of photopolymerization initiator added and the development conditions.

**Table 6**

| Ex.No. | Photopolymerization initiator | Exposure (mJ/cm²) |
|---|---|---|
| 15 | 2,2-dimethoxy-2-phenylacetophenone (1.00 g) | 600 |
| | | |
| 21 | 3,3'-4,4'-tetra-(tert-butylperoxycarbonyl) benzophenone (0.80 g) | 540 |
| | | |
| 22 | isopropyl benzoin ether (2.00 g) | 840 |
| | | |
| 23 | benzyl dimethyl ketal (0.50 g) | 960 |
| | | |
| 24 | 2-methylthioxanthone (0.20 g) | 1,200 |
| | | |
| 25 | 2,4,6-tris(trichloromethyl)-1,3,5-triazine (1.50 g) | 720 |
| | | |
| 26 | benzoyl peroxide (1.50 g) | 840 |
| | | |
| 27 | 2,4-bis(trichloromethyl)-6-phenyl-1,3,5-triazine (0.50 g) | 1,200 |
| 28 | (η⁶-benzene) (η⁵-cyclopentadienyl) (II) hexafluorophosphate (2.00 g) | 720 |
| | | |
| 29 | N-phenylglycine (1.80 g) | 840 |

### Example 30

A photosensitive solution was made up which comprised the following compounds:

| | |
|---|---|
| varnish of silicone-modified polyamide precursor: silicone-modified polyamide precursor (13.5% by weight) | 50.0 g |
| acrylic oligomer: oligomers ① | 5.0 g |
| monomer: isocyanuric acid EO (n = 3)·ε-caprolactone modified triacrylate | 5.0 g |
| photopolymerization initiator: 2-hydroxy-2-methyl propiophenone | 1.50 g |

The photosensitive solution having the above-described composition was spin-coated on a pretreated Si wafer having a diameter of 7.6 cm (3 in.), and the coated wafer was prebaked at 100°C for 1 hr. to produce a photosensitive plate. The thickness of the film after prebaking was 8 µm.

A negative type glass mask having a minimum pattern width of 30 µm was provided on the photosensitive plate and irradiated with a high-pressure mercury lamp for 40 sec.

Then, the photosensitive plate was subjected to ultrasonic wave development with a mixed solution comprising N-methyl-2-pyrrolidone and methyl celloslove and then rinsed in isopropyl alcohol, thereby developing the plate. The unexposed region was eluted, leaving behind the exposed pattern region only.

The pattern region was then heated at 280°C for 30 min to convert the residual polyimide precursor into a polyimide resin. Although the depth of yellow colour of the pattern region was slightly increased, no other change was observed.

The pattern was observed under a microscope, and no breaks were found. The thermal decomposition temperature of the resin in the pattern region was measured, and as a result, the resin was found to be stable up to about 330°C.

### Example 31

Viaholes were formed by the use of a photosensitive solution having the same composition as that of above-described Example 30 and following the general procedure of Example 30, except that a pretreated ceramic substrate (Al₂O₃) having a bell size, a pretreated glass substrate having a size of 70 x 70 x 1 mm, a pretreated aluminum plate having a size of 70 x 70 x 2 mm and a pretreated copper plate having a size of 70 x 70 x 1 mm were used instead of the 7.6 cm (3 in.) diameter Si wafer and use was made of a negative type glass mask having a minimum viahole size of 50 µmφ. When the test specimens were observed under a microscope after curing, it was found that via-holes having a size up to 50 µmφ were formed.

As can be appreciated from the above description, a photosensitive, heat-resistant resin can be provided at a low cost through the practice of the present invention. This resin has not only a heat resistance sufficient for use in producing thin layer insulating films, surface protective films or the like for circuit substrates, printed boards and wiring boards for high-density mounting including multichip modules or the like, but also has a heat resistance above soldering temperatures and further, as opposed to the conventional procedures, does not bring about any reduction in film thickness caused by the photosensitive group; this makes it possible to form a pattern having a high dimensional accuracy.

Further, according to the present invention, it is possible to provide a useful heat-resistant insulating film which is superior to the conventional insulating film in its adhesion to the base material and has a good moisture resistance, various excellent properties attributable to inorganic high-molecular materials when these are used in the production of the film, such as phosphazene compounds when these are used in the production of the film, including hardness, abrasion resistance and chemical resistance, excellent photosensitivity, heat resistance to temperatures above the soldering temperature and considerably lower cost than when the polyimide resins alone are used. Other effects of the present invention can be easily understood from the above detailed description of the invention.

## Claims

1. A film forming, photosensitive, heat-resistant composition, which comprises a varnish of a polyimide precursor having no photosensitivity and capable of undergoing a cyclodehydration reaction upon heating to form a polyimide, a photopolymerizable component compatible with said polyimide precursor varnish and capable of providing a thermostable polymer upon being photopolymerized, said component being selected from photopolymerizable trifunctional or higher functional acrylic or methacrylic monomers and oligomers and photoplymerizable phosphazenic monomers or oligomers, and a polymerization initiator capable of initiating polymerization of said photopolymerizable component.

2. A photosensitive, heat-resistant resin composition according to claim 1, in which said trifunctional or higher functional acrylic or methacrylic monomer or oligomer is represented by the following formula: 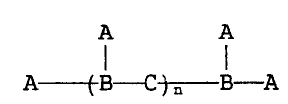 in which
A is an acrylic acid or methacrylic acid-derived residue,
B is a polyhydric alcohol derived residue,
C is a polybasic acid derived residue, and
n is a positive integer.

3. A photosensitive, heat-resistant resin composition according to claim 1, in which said acrylic or methacrylic monomer or oligomer has an isocyanurate structure.

4. A photosensitive, heat resistant resin composition according to any preceding claim, in which said polymerization initiator is a benzoin ether compound, a ketal compound, an acetopenone compound, a benzophenone compound, a thioxanthone compound, an organic peroxide, N-phenylglycine, a triazine compound or an allene-iron complex.

5. A process for patterning a substrate, which comprises the steps of:
coating a substrate with a photosensitive, heat-resistant resin composition as claimed in any preceding claim;
selectively exposing the resulting coating of the photosensitive, heat-resistant resin composition in accordance with a predetermined pattern to induce photopolymerization of said photopolymerizable component in a pattern matching the selected pattern;
selectively removing a region of said coating other than that where a polymer of said monomer or oligomer has been formed; and
heat-treating the residual coating to cause cyclodehydration and curing of said polyimide precursor contained in the coating thereby forming a patterned film of the polyimide and the thermostable polymer.

6. A patterning process according to claim 5, which is used in production of a substrate for an electrically conductive circuit for high-density mounting.

7. A patterning process according to claim 6, which is used in the production of printed circuit, a printed circuit board, a printed wiring board or an electronic component.

8. A circuit board, which comprises a substrate, and two or more electrically conductive layers applied over the substrate, the electrically conductive layers being insulated from each other by means of upper and lower layer-insulating films, and being electrically connected with another electrically conductive layer through an interlayer conductor occupying a viahole in the layer-insulating film sandwiched therebetween, and in which the viahole-containing layer-insulating film has been prepared by the steps of:
providing an electrically conductive layer as a base material a photosensitive, heat resistant resin composition as claimed in any one of claims 1 to 4;
selectively exposing the resulting coating of the photosensitive, heat-resistant resin composition in accordance with a predetermined pattern to induce photopolymerization of said photopolymerizable component in a pattern matching the selected pattern,
selectively removing a region of said coating other than that where a polymer of said monomer or oligomer has been formed; and
heat-treating the residual coating to cause cyclodehydration and curing of said polyimide precursor contained in the coating thereby forming a patterned film of the polyimide and the thermostable polymer.

9. A circuit board according to claim 8, in which the substrate is a semiconductor substrate, a ceramic substrate, a metallic substrate, an inorganic substrate or an organic substrate.

## Patentansprüche

1. Filmbildende, fotoempfindliche, wärmebeständige Zusammensetzung, die einen Lack aus einem Polyimid-Präkursor umfaßt, der keine Fotoempfindlichkeit besitzt und einer Cyclodehydratisierungsreaktion beim Erhitzen unterzogen werden kann, um ein Polyimid zu bilden, eine fotopolymerisierbare Komponente, die mit dem Polyimid-Präkursor-Lack kompatibel ist und beim Fotopolymerisieren ein thermostabiles Polymer vorsehen kann, welche Komponente ausgewählt ist aus fotopolymerisierbaren trifunktionellen oder höherfunktionellen Acryl- oder Methacrylmonomeren und -oligomeren und fotopolymerisierbaren phosphazenischen Monomeren oder Oligomeren, und einen Polymerisationsinitiator, der die Polymerisation der fotopolymerisierbaren Komponente initiieren kann.

2. Fotoempfindliche, wärmebeständige Harzzusammensetzung nach Anspruch 1, bei der das trifunktionelle oder höherfunktionelle Acryl- oder Methacrylmonomer oder -oligomer durch die folgende Formel dargestellt wird: 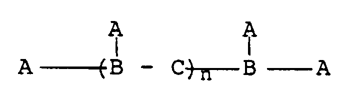 wobei
A ein Acrylsäure- oder Methacrylsäurederivatrest ist,
B ein Polyalkoholderivatrest ist,
C ein Derivatrest einer mehrwertigen Säure ist und
n eine positive ganze Zahl ist.

3. Fotoempfindliche, wärmebeständige Harzzusammensetzung nach Anspruch 1, bei der das Acryl- oder Methacrylmonomer oder -oligomer eine Isocyanuratstruktur hat.

4. Fotoempfindliche, wärmebeständige Harzzusammensetzung nach irgendeinem vorhergehenden Anspruch, bei der der Polymerisationsinitiator eine Benzoinetherverbindung, eine Ketalverbindung, eine Acetophenonverbindung, eine Benzophenonverbindung, eine Thioxanthonverbindung, ein organisches Peroxid, N-Phenylglycin, eine Triazinverbindung oder ein Allen-Eisen-Komplex ist.

5. Prozeß zum Mustern eines Substrates, mit den folgenden Schritten:
Beschichten eines Substrates mit einer fotoempfindlichen, wärmebeständigen Harzzusammensetzung nach irgendeinem vorhergehenden Anspruch;
selektives Belichten der resultierenden Beschichtung aus der fotoempfindlichen, wärmebeständigen Harzzusammensetzung gemäß einem vorbestimmten Muster, um eine Fotopolymerisation der fotopolymerisierbaren Komponente in einem Muster zu induzieren, das mit dem selektierten Muster übereinstimmt;
selektives Entfernen einer Zone der Beschichtung, die nicht diejenige ist, wo ein Polymer aus dem Monomer oder Oligomer gebildet worden ist; und
Wärmebehandlung der zurückbleibenden Beschichtung, um eine Cyclodehydratisierung und Härtung des Polyimid-Präkursors zu bewirken, der in der Beschichtung enthalten ist, um dadurch einen gemusterten Film aus dem Polyimid und dem thermostabilen Polymer zu bilden.

6. Musterungsprozeß nach Anspruch 5, der bei der Herstellung eines Substrates für eine elektrisch leitfähige Schaltung zur Montage mit hoher Dichte verwendet wird.

7. Musterungsprozeß nach Anspruch 6, der bei der Herstellung einer gedruckten Schaltung, einer gedruckten Schaltungsplatte, einer gedruckten Verdrahtungsplatte oder eines elektronischen Bauelementes verwendet wird.

8. Schaltungsplatte, die ein Substrat umfaßt, und zwei oder mehr elektrisch leitfähige Schichten, die über dem Substrat aufgetragen sind, welche elektrisch leitfähigen Schichten durch obere und untere schichtisolierende Filme voneinander isoliert sind und durch einen Zwischenschichtleiter, der ein Durchgangsloch in dem schichtisolierenden Film belegt, der sandwichartig zwischen ihnen angeordnet ist, elektrisch miteinander verbunden sind, und bei der der schichtisolierende Film, der das Durchgangsloch enthält, durch die folgenden Schritte hergestellt worden ist:
Vorsehen, auf einer elektrisch leitfähigen Schicht als Basismaterial, einer fotoempfindlichen, wärmebeständigen Harzzusammensetzung nach irgendeinem der Ansprüche 1 bis 4;
selektives Belichten der resultierenden Beschichtung aus der fotoempfindlichen, wärmebeständigen Harzzusammensetzung gemäß einem vorbestimmten Muster, um eine Fotopolymerisation der fotopolymerisierbaren Komponente in einem Muster zu induzieren, das mit dem selektierten Muster übereinstimmt;
selektives Entfernen einer Zone der Beschichtung, die nicht diejenige ist, wo ein Polymer aus dem Monomer oder Oligomer gebildet worden ist; und
Wärmebehandlung der zurückbleibenden Beschichtung, um eine Cyclodehydratisierung und Härtung des Polyimid-Präkursors zu bewirken, der in der Beschichtung enthalten ist, wodurch ein gemusterter Film aus dem Polyimid und dem thermostabilen Polymer gebildet wird.

9. Schaltungsplatte nach Anspruch 8, bei der das Substrat ein Halbleitersubstrat, ein Keramiksubstrat, ein Metallsubstrat, ein anorganisches Substrat oder ein organisches Substrat ist.

## Revendications

1. Composition formant un film, photosensible, résistant à la chaleur, qui comprend un vernis d'un précurseur de polyimide dépourvu de photosensibilité et capable de subir une réaction de cyclodéshydrataion par chauffage avec formation d'un polyimide, un composant photopolymérisable compatible avec ledit vernis de précurseur de polyimide et capable de donner un polymère thermostable par photopolymérisation, ledit composant étant choisi parmi les monomères et oligomères acryliques ou méthacryliques photopolymérisables trifonctionnels ou plus, et les monomères ou oligomères phosphazéniques photopolymérisables, et un initiateur de polymérisation capable d'initier la polymérisation dudit composant photopolymérisable.

2. Composition de résine photosensible, résistant à la chaleur selon la revendication 1, dans laquelle ledit monomère ou oligomère acrylique ou méthacrylique trifonctionnel ou plus est représenté par la formule suivante : 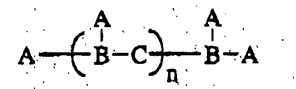 où
A est un reste dérivé d'acide acrylique ou d'acide méthacrylique ;
B est un reste dérivé d'un alcool polyhydroxylé,
C est un reste dérivé d'un acide polyacide et
n est un entier positif.

3. Composition de résine photosensible, résistant à la chaleur selon la revendication 1, dans laquelle ledit monomère ou oligomère acrylique ou méthacrylique a une structure isocyanurate.

4. Composition de résine photosensible, résistant à la chaleur selon une quelconque des revendications précédentes, dans laquelle ledit initiateur de polymérisation est un composé ester de benzoïne, un composé cétal, un composé d'acétophénone, un composé de benzophénone, un composé de thioxanthone, un peroxyde organique, la N-phénylglycine, un composé triazinique ou un complexe allène - fer.

5. Procédé pour réaliser un motif sur un substrat, comprenant les étapes :
de recouvrement d'un substrat par une composition de résine photosensible, résistant à la chaleur selon une quelconque des revendications précédentes ;
de l'exposition sélective du revêtement de composition de résine photosensible résistant à la chaleur obtenu, selon un motif prédéfini pour induire la photopolymérisation dudit composant photopolymérisable selon un motif correspondant au motif choisi ;
de l'enlèvement sélectif d'une région dudit revêtement autre que celle où un polymère dudit monomère où oligomère a été formé et
du traitement thermique du revêtement résiduel pour entraîner la cyclodéshydratation et le durcissement dudit précurseur de polyimide contenu dans le revêtement avec ainsi formation d'un film à motif en polyimide et en polymère thermostable.

6. Procédé de formation de motif selon la revendication 5, utilisé dans la production d'un substrat pour un circuit conducteur électrique pour un montage à haute densité.

7. Procédé de formation de motif selon la revendication 6, utilisé dans la production d'un circuit imprimé, d'une plaquette de circuit imprimé, d'une planche de câblage imprimé ou d'un composant électronique.

8. Plaquette de circuits, comprenant un substrat et deux couches conductrices d'électricité ou plus appliquées sur le substrat, les couches conductrices d'électricité étant isolées les unes des autres au moyen de films supérieur et inférieur isolant les couches et étant reliées électriquement avec une autre couche conduisant l'électricité par un conducteur intercouche occupant un trou débouchant dans le film isolant les couches intercalé en sandwich entre elles et dans laquelle le film isolant les couches contenant le trou débouchant a été préparé par les étapes :
de recouvrement d'un substrat par une composition de résine photosensible, résistant à la chaleur selon une quelconque des revendications 1 à 4 ;
de l'exposition sélective du revêtement de composition de résine photosensible résistant à la chaleur obtenu, selon un motif prédéfini pour induire la photopolymérisation dudit composant photopolymérisable selon un motif correspondant au motif choisi ;
de l'enlèvement sélectif d'une région dudit revêtement autre que celle où un polymère dudit monomère ou oligomère a été formé et
du traitement thermique du revêtement résiduel pour entraîner la cyclodéshydratation et le durcissement dudit précurseur de polyimide contenu dans le revêtement avec ainsi formation d'un film à motif en polyimide et en polymère thermostable.

9. Plaquette de circuits selon la revendication 8, dans laquelle le substrat est un substrat semi-conducteur, un substrat céramique, un substrat métallique, un substrat minéral ou un substrat organique.
